# EUROPÄISCHE PATENTANMELDUNG

(11) **EP 2 662 970 A2**
(43) Veröffentlichungstag der Anmeldung: **13.11.2013**
(21) Anmeldenummer: 13167124.0
(22) Anmeldetag: 08.05.2013
(51) Int. Cl.: H02M 7/797

(54) **Schaltungsanordnung**

(30) Priorität: 09.05.2012 DE 102012104085; 01.08.2012 DE 102012107032
(71) Anmelder: Steca Elektronik GmbH, 87700 Memmingen (DE)
(72) Erfinder: Schekulin, Dirk, 9052 Niederteufen (CH); Winter, Andreas, 87743 Egg a. d. Günz (DE); Linse, Stefan, 87700 Memmingen (DE); Kloos, Dieter, 74579 Fichtenau-Krettenbach (DE)
(74) Vertreter: Pfister, Stefan Helmut Ulrich

(57) **Zusammenfassung**

Die Erfindung betrifft eine Schaltungsanordnung. Sie umfasst mindestens zwei an ihren Hauptanschlüssen in Stromleitungsrichtung hintereinander angeordnete Halbleiterschalter. Die wirksame Kapazität zumindest eines Halbleiterschalters wird über einen Ladestrompfad zwangsweise vorgeladen.

## Beschreibung

Die Erfindung betrifft eine Schaltungsanordnung, wie sie insbesondere in Gleichstromstellern oder Umrichtern verwendet werden.

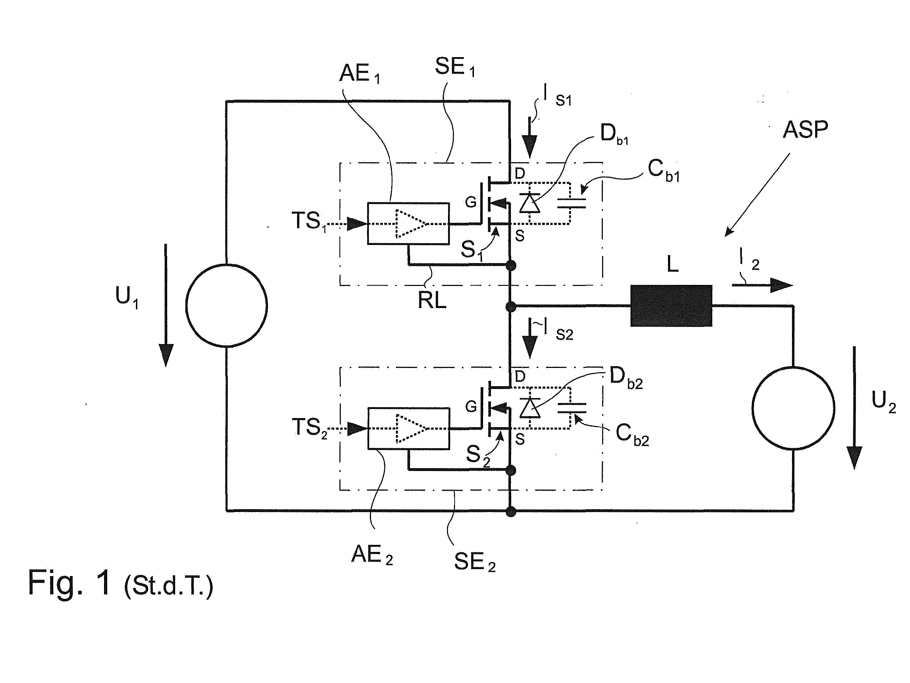

In Fig. 1 der beiliegenden Zeichnung ist ein schematisches Schaltbild einer bekannten Schaltungsanordnung eines bidirektionalen Gleichstromstellers dargestellt. Hierbei sind zwei gleichartige Schaltereinheiten SE₁ und SE₂ in Reihe hintereinander geschaltet, die an der zweiten Schaltereinheit SE₂ abfallende mittlere Ausgangsspannung U₂ dient als Ausgangsstrompfad ASP der Entnahme des Laststromes I₂. Durch abwechselndes Ein- und Ausschalten der Schaltereinheiten SE₁ und SE₂ kann zwischen der eingangsseitigen Spannungsquelle U₁ und der ausgangsseitigen Spannungsquelle U₂ (unter Bedingung U₁ ≥ U₂) beliebig Energie ausgetauscht werden.

Es sei angenommen, dass der Laststrom I₂, der in der ausgangsseitigen Spannungsquelle U₂ fließt, positiv und die im Ausgangsstrompfad ASP, an welcher die ausgangsseitige Spannungsquelle U₂ anliegt und in welcher der Laststrom I₂ fließt, Drossel L, sehr groß ist, sodass eine vernachlässigbare Stromwelligkeit durch die Drossel L auftritt.

Die eingangsseitige Spannung U₁ fällt dabei über zwei in Reihe angeordnete Halbleiterschalter S₁ und S₂ ab. Die ausgangsseitige Spannung U₂ ist dabei der mittlere Spannungsabfall an dem zweiten in Reihe geschalteten Halbleiterschalter S₂.

Jeder Halbleiterschalter S₁, S₂ ist Teil einer Schaltereinheit SE₁ bzw. SE₂, die eine Ansteuereinheit AE₁, AE₂, insbesondere mit einer Ansteuerungs- und Ladeschaltung sowie einem Taktsignalgeber TS₁ bzw. TS₂, aufweist.

Zunächst sei die Schaltereinheit SE₁ eingeschaltet, das heißt es liegt momentan ein positives Taktsignal TS₁ am Eingang der Ansteuereinheit AE₁ und somit auch am Ausgang der Ansteuereinheit AE₁ an. Hieraus resultiert, dass der z.B. als MOSFET ausgebildete Halbleiterschalter S₁ in Vorwärtsrichtung leitend ist. Der Schalterstrom I_{S1} ist positiv und gleich dem Laststrom I₂.

Die Schaltereinheit SE₂ sei ausgeschaltet, sodass der Schalterstrom I_{S2} gleich 0 ist. Als Schalterstrom I_{S1} oder I_{S2} wird dabei der Strom beschrieben, der im eingeschalteten Falle, durch den jeweiligen Halbleiterschalter S₁ bzw. S₂ zu fließen vermag.

Bekannte Halbleiterschalter, wie sie in Fig. 1 mit den Halbleiterschaltern S₁ oder S₂ verwendet werden, sind keine idealen Schalter, sondern besitzen aufgrund ihrer Halbleiterstruktur noch weitere, oftmals parasitäre Eigenschaften, denen durch ein entsprechendes Ersatzschaltbild in der gezeigten Schaltungsanordnung Rechnung getragen wird. So besteht bei einem als MOSFET ausgebildeten Halbleiterschalter zwischen Source- (S) und Drain- (D) Anschluss eine als Bodydiode (D_{b}) sowie eine zur Bodydiode (D_{b}) parallel geschaltete wirksame Kapazität (C_{b}). Zu beachten ist, dass die Bodydiode D_{b} zwischen Source (S) und Drain (D) des jeweiligen Halbleiterschalters S₁/S₂ leitend ist.

Die beiden Schaltereinheiten SE₁, SE₂ sind gleichartig aufgebaut. Für eine bessere Unterscheidung der einzelnen Begriffe sind mit dem Index 1 jeweils Elemente der ersten Schaltereinheit SE1 und mit dem Index 2 Elemente der zweiten Schaltereinheit SE₂ gekennzeichnet.

Wird nun der Halbleiterschalter S₁ ausgeschaltet (der Halbleiterschalter S₂ ist ebenfalls ausgeschaltet), dann muss der Strom weiterfließen, es findet eine Kommutierung auf den Freilaufpfad der zweiten Schaltereinheit SE₂ statt. Dieser Freilaufpfad wird gebildet durch die Bodydiode (D_{b2}) des als MOSFET ausgebildeten Halbleiterschalters SE₂. Als Kommutierung wird ein Vorgang bezeichnet, bei dem ein Stromfluss von einem Zweig zu einem anderen übergeht.

Aufgrund der parasitären Elemente in dem Halbleiterschalter S₁, S₂, hierzu zählen die intrinsische Diode oder Bodydiode D_{b1}, D_{b2}, die wirksamen Kapazitäten C_{b1}, C_{b2} zwischen den Source- und Drainanschlüssen des Halbleiterschalters S₁, S₂ sowie weitere Streuinduktivitäten, passiert im Leistungspfad nun folgendes:

Der Abschaltvorgang des Halbleiterschalters S₁ sei im Vergleich zu den nachfolgenden Vorgängen sehr kurz. Damit lädt sich die Ausgangskapazität C_{b1}, die parallel zur Bodydiode D_{b1} des Halbleiterschalters S₁ wirkt, durch den weiterhin fließenden Laststrom auf. Da es sich um eine Halbbrückenanordnung handelt, die über die eingangsseitige Spannungsquelle U₁ geklemmt ist, muss sich die Ausgangskapazität C_{b2} am zweiten Halbleiterschalter S₂ entladen. Diese entlädt sich solange, bis die Bodydiode D_{b2} des Halbleiterschalters S₂ leitend wird. Wenn der Laststrom I₂ vollständig durch die Bodydiode D_{b2} des noch gesperrten Halbleiterschalters S₂ fließt, ist der Kommutierungsvorgang abgeschlossen.

Der Stromfluss durch die Bodydiode D_{b2} des Halbleiterschalters S₂ erzeugt einen Spannungsabfall, der zu signifikanten Leitendverlusten führt. Bevorzugterweise ist der Halbleiterschalter S₂ (wie auch der Halbleiterschalter S₁) als MOSFET und somit als unipolares Bauelement ausgebildet, wodurch man jetzt den Halbleiterschalter S₂ einschalten (der Halbleiterschalter S₁ ist nach wie vor ausgeschaltet) kann und es liegt dann der Leitungswiderstand des MOSFETs parallel zu seiner Bodydiode D_{b2}. Dadurch werden nun die Leitendverluste erheblich reduziert. Im Idealzustand fließt dann der gesamte Laststrom I₂ rückwärts über den Bahnwiderstand des als MOSFET ausgebildeten Halbleiterschalters S₂ und seine Bodydiode D_{b2} ist stromlos. Man bezeichnet diesen Zustand auch als Synchronfreilauf.

Bei der Rückkommutierung des Stromflusses von der zweiten Schaltereinheit SE₂ zur ersten Schaltereinheit SE₁ muss zunächst der Halbleiterschalter S₂ in den gesperrten Zustand versetzt werden. Danach fließt der Laststrom I₂ wieder vollständig durch die Bodydiode D_{b2} des Halbleiterschalters S₂ der zweiten Schaltereinheit SE₂. Jetzt kann der Halbleiterschalter S₁ eingeschaltet werden. Es muss nun zunächst ein erheblicher Rückstrom durch die Bodydiode D_{b2} des zweiten Halbleiterschalters S₂ fließen, damit die Ladungsträger ausgeräumt werden können und die Diode D_{b2} in den sperrenden Zustand versetzt wird. Dieser Effekt ist als Sperrverzug oder Recovery-Effekt bekannt. Sperrt die Diode, müssen noch die nichtlinearen Kapazitäten, also die intrinsischen, an dem Halbleiterschalter wirksamen Kapazitäten, umgeladen werden, bis der Kommutierungsvorgang abgeschlossen ist und der Laststrom wieder vollständig über den Halbleiterschalter S₁ der ersten Schaltereinheit SE₁ fließt.

Insbesondere diese Rückkommutierung ist sehr verlustbehaftet, da die Bodydioden der als MOSFETs ausgebildeten Halbleiterschalter dynamisch viel schlechter sind als schnelle externe Dioden. Auch ist die nichtlineare Ausgangskapazität der MOSFETs bei der Rückkommutierung noch wirksam und verursacht zusätzliche Verluste.

Der Anwendungsbereich gattungsgemäßer Schaltungsanordnungen liegt zum Beispiel in Gleichstromstellern oder Umrichtern, bei welchen ein möglichst hoher Wirkungsgrad, also möglichst geringe Verlustleistungen, angestrebt werden, da diese Verlustleistungen als Verlustwärme nur mit entsprechenden zusätzlichen Aufwand abzuführen und zu kühlen sind und natürlich auch die gesamte elektrische Effizienz bei einem Gleichstromsteller oder Umrichter negativ beeinflusst.

Im Sinne dieser Anmeldung umfasst dabei der Begriff Umrichter (als Ober- oder Sammelbegriff) sowohl Gleichstrom- wie auch Wechselstromumrichter und somit sowohl Wechselrichter wie auch Gleichrichter. Ein Wechselstromumrichter ist dabei ein Stromrichter beziehungsweise Umrichter, der aus einer Wechselspannung eine in Frequenz und/oder Amplitude unterschiedliche Wechselspannung generiert. Als Wechselrichter, insbesondere als Solarwechselrichter, wird dabei ein Gerät bezeichnet, dass Gleichspannung/Gleichstrom in Wechselspannung/Wechselstrom umrichtet. Gleichrichter dienen zur Umwandlung von Wechselspannung in Gleichspannung.

Der vorliegenden Erfindung liegt daher die Aufgabe zugrunde, den Stand der Technik derart zu verbessern, dass der möglichst verlustarme Betrieb von Halbleiterschaltern im Kommutierungsbetrieb möglich ist.

Die erfindungsgemäße Aufgabe wird zunächst durch ein Verfahren zum Aufladen einer an den Hauptanschlüssen eines Halbleiterschalters wirksamen Kapazität gelöst, wobei eine Vorladung der wirksamen Kapazität über einen Ladestrompfad gesteuert wird und zu dem Halbleiterschalter mindestens ein weiterer Halbleiterschalter vorgesehen ist.

Des Weiteren löst die nachfolgend beschriebene Schaltungsanordnung diese erfindungsgemäße Aufgabe, wobei die Schaltungsanordnung mindestens zwei an ihren Hauptanschlüssen in Stromleitungsrichtung hintereinander angeordnete Halbleiterschalter umfasst, wobei mindestens einem Halbleiterschalter eine wirksame Kapazität zugeordnet ist und zur zwangsweisen Steuerung einer Vorladung der wirksamen Kapazität ein Ladestrompfad vorgesehen ist.

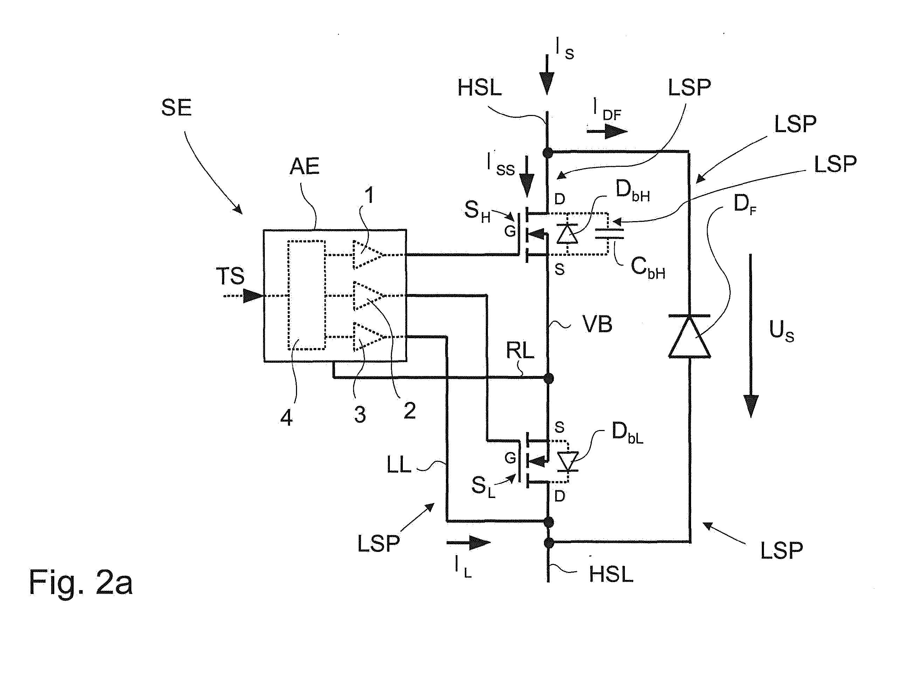

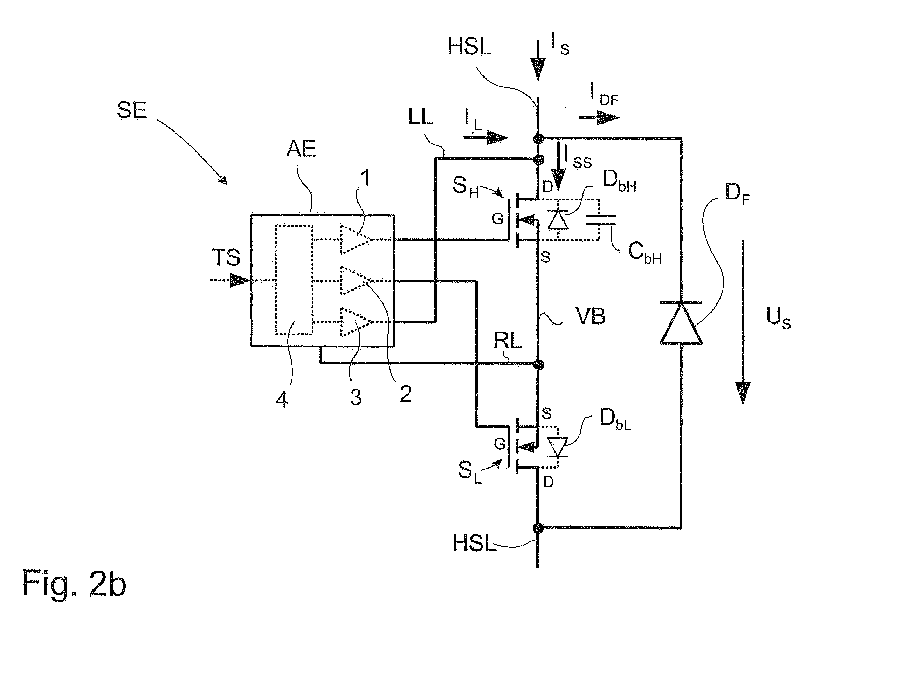

Die erfindungsgemäße Schaltungsanordnung ist in ihrem prinzipiellen Aufbau in Fig. 2a oder 2b gezeigt.

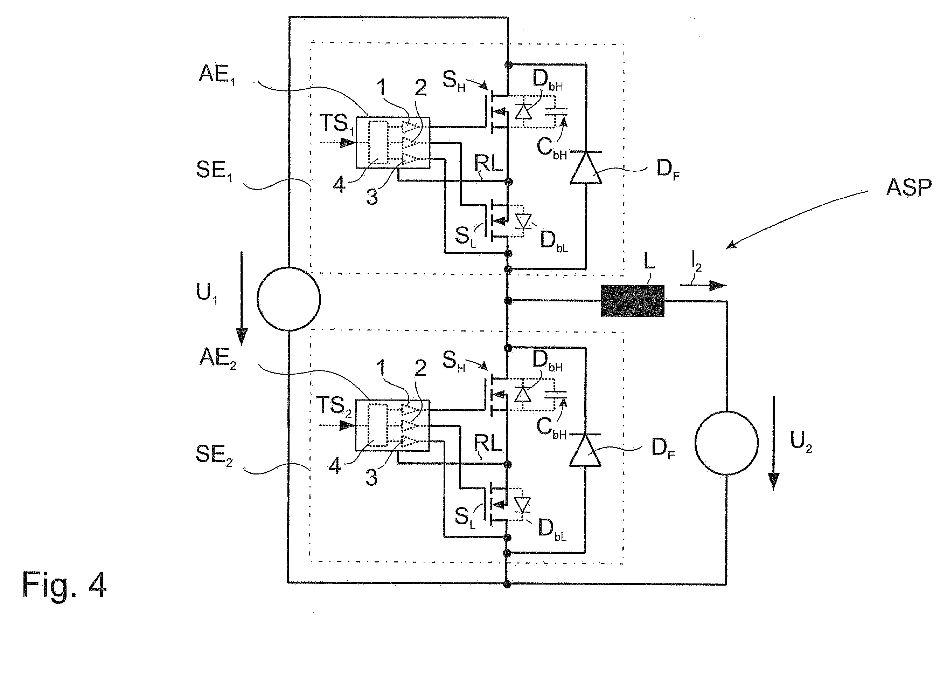

Hierbei ist zu beachten, dass die in Fig. 2a und 2b gezeigte Schaltungsanordnung nicht dem Schaltbild nach Fig. 1 entspricht. Die erfindungsgemäße Schaltungsanordnung bzw. so, wie die Erfindung in Fig. 2a, 2b beispielhaft (nicht abschließend) beschrieben und gezeigt ist, bildet vielmehr eine Schaltereinheit SE₁ bzw. SE₂, in der Halbbrückenschaltung gemäß Fig. 1. Insbesondere wird dies deutlich, wenn man Fig. 4 betrachtet, bei welcher die erfindungsgemäße Schaltungsanordnung in der mit dem Vorschlag nach dem Stand der Technik (Fig. 1) gezeigten Schaltung realisiert ist.

Die beiden in der Schaltungsanordnung bzw. Schaltereinheit eingesetzten Halbleiterschalter können im Prinzip synchron geschaltet werden.

Es wird ein zusätzlicher Ladestrompfad gemäß der Erfindung vorgeschlagen, über die eine Vorladung bzw. Aufladung der Ausgangskapazitäten der an den Halbleiterschaltern wirksamen (intrinsischen) Kapazitäten. Bei der Rückkommutierung ist daher die Ausgangskapazität der Halbleiterschalter aufgrund der Vorladung bereits sehr klein, woraus resultiert, dass es möglich ist, hartgeschaltete (also schnell geschaltete) Kommutierungszellen mit sehr geringen Leitend- und Schaltverlusten zu realisieren. Das erfindungsgemäße Verfahren und die erfindungsgemäße Schaltungsanordnung verbessern den Wirkungsgrad entsprechend ausgestatteter Geräte, wie z.B. Gleichstromstellern oder Umrichtern, die ebenfalls von der Erfindung umfasst und beansprucht sind.

Dabei ist der Ladestrompfad Bestandteil oder Teil der Ladeschaltung, die einen entsprechenden Ladestrom zur Verfügung stellt, um die wirksame Kapazität auf- bzw. vorzuladen.

In einer bevorzugten Ausgestaltung der Erfindung ist vorgesehen, dass parallel zu den mindestens zwei in einer Reihe angeordneten Halbleiterschaltern eine Diode angeordnet ist und der zum Vor- bzw. Aufladen der Kapazität vorgesehene Ladestrom über die Diode geleitet wird. Wie beschrieben, sind durch die Aufladung der Kapazität die Ausgangskapazitäten an den Halbleiterschaltern aufgrund der Vorladung bereits sehr klein und die hieraus resultierenden Verluste sehr gering. Der Begriff "Vorladung" bezieht sich dabei zeitlich auf die Abfolge des Kommutierens bzw. Rückkommutierens, wobei die Vorladung der Kapazität insbesondere dann erfolgt, wenn kein Laststrom durch die in Reihe angeordneten Halbleiterschalter fließt. Der Begriff Vorladung bezeichnet damit auch eine vorbereitende Maßnahme, die bei der Rückkommutierung dann verwendet wird.

Die erfindungsgemäß parallel zu den mindestens zwei in Reihe angeordneten Halbleiterschaltern vorgesehene Diode ist zum Beispiel eine hochwertige Recoverydiode, die bei genügend kleinen Spannungsabfällen über die beiden hintereinander angeordneten Halbleiterschaltern während des Synchronfreilaufes nur der Kommutierung dient und eine sehr kleine Stromflussdauer aufweist. Daher ist es möglich, diese Diode verhältnismäßig klein auszulegen. Bei der Rückkommutierung ist dann im Wesentlichen nur noch die Sperrverzugsladung dieser Diode aufzubringen, die Ausgangskapazitäten an zumindest einem der beiden Halbleiterschalter sind aufgrund der Vorladung bereits sehr klein.

Durch den erfindungsgemäßen Vorschlag ist es möglich, hartgeschaltete Kommutierungszellen mit sehr geringen Leitend- und Schaltverlusten zu realisieren. Aufgrund der Verwendung von unipolaren Leistungsschaltern als Halbleiterschalter ist zudem der Verlustanteil je Bauelement durch Parallelschaltung derart weit absenkbar, dass selbst Schaltungsanordnungen für größere Leistungen, wie sie z.B. für Gleichstromsteller oder Umrichter typisch sind, problemlos realisierbar sind.

In einer bevorzugten Ausgestaltung der Erfindung ist vorgesehen, dass die Vor- bzw. Aufladung der Kapazität dann erfolgt, wenn kein Laststrom durch die hintereinander angeordneten Halbleiterschalter fließt. Wie bereits ausgeführt, ist die erfindungsgemäße Schaltungsanordnung eine Schaltereinheit einer Brückenschaltung in einem Wechselrichter oder Gleichstromsteller. Daraus resultiert, dass die beiden hintereinander angeordneten Halbleiterschalter gleichsinnig geschaltet werden, also beide gleichzeitig leitend oder sperrend sind. Es ist möglich, dass der Zeitpunkt, bei welchem der jeweilige Schalter sperrt oder leitend wird, durch individuelle Anpassungen, z.B. durch entsprechende Gate-Widerstände, einstellbar ist, was keinen Widerspruch darstellt. Dadurch ist der individuelle Zeitpunkt des Ein- beziehungsweise Ausschalters einstellbar und anpassbar. Um die parasitären wirksamen Kapazitäten durch die geschlossenen Halbleiterschalter nicht kurzzuschließen, werden diese dann aufgeladen, wenn die Halbleiterschalter geöffnet sind, also wenn kein Laststrom durch die Schalteranordnung/Schaltereinheit fließt.

In einer erfindungsgemäßen Weiterentwicklung wird vorgesehen, dass die beiden, bevorzugt gleichartigen, hintereinander angeordneten Halbleiterschaltern von einer Ansteuerungseinheit synchron bzw. gleichartig angesteuert werden.

Hiernach werden als Halbleiterschalter bevorzugt unipolare Halbleiterschalter z.B. Feldeffekttransistoren, MOSFET oder JFET verwendet. Die Gleichartigkeit bezieht sich insofern auf den gleichen Typ von Transistor, also z.B. normalsperrend oder normalleitend, n-Kanal- oder p-Kanal-MOSFET. Der Begriff Gleichartigkeit umschließt auch eine identische Ausgestaltung der beiden hintereinander angeordneten Halbleiterschalter, ist hierauf aber in keinster Weise beschränkt. Die beiden Halbleiterschalter können durchaus unterschiedliche Parameter aufweisen, wie dies noch ausgeführt werden wird, da sie in der Schaltungsanordnung unter Umständen unterschiedlichen Umgebungsparametern ausgesetzt sind.

Geschickterweise erfolgt eine zwangsweise Vor- bzw. Aufladung, wobei die zwangsweise Vor- bzw. Aufladung durch die Steuerung erzwungen wird, die z.B. den Ladestrom einschaltet, wenn kein Laststrom durch die Halbleiterschalter fließt.

Der erfindungsgemäße Effekt taucht bereits auf, wenn die wirksame Kapazität zumindest einer der beiden oder mehreren Halbleiterschaltern vor- bzw. aufgeladen wird. Werden beide oder alle an den Halbleiterschaltern wirksamen Kapazitäten vorgeladen, verbessert sich die Gesamteffizienz der erfindungsgemäßen Schaltungsanordnung bzw. des Verfahrens entsprechend.

Nachfolgend wird die Reihenfolge der beiden hintereinander angeordneten Halbleiterschaltern definiert: Wie beschrieben, sind die beiden Halbleiterschalter an den Hauptanschlüssen in Reihe geschaltet. Im normalen Betriebsfall fließt ein Laststrom durch die hintereinander geschalteten Halbleiterschalter, wodurch die positive Stromrichtung allgemein definiert ist, ohne diese positive Stromrichtung auf den Schaltungszustand der geöffneten Halbleiterschalter, welcher die Leitung des Laststromes erlaubt, zu beschränken. Über den Begriff positive Stromrichtung ist daher die Reihenfolge der Halbleiterschalter unabhängig vom Fluß des Laststromes definiert.

In der erfindungsgemäßen Schaltungsanordnung werden mehrere Varianten vorgesehen, die die Ladeschaltung über eine Ladeleitung den Ladestrom in die hintereinander angeordneten Halbleiterschalter einprägt. Bei einer ersten Variante wird der Ladestrom über eine Ladeleitung vor dem, bezogen auf die positive Stromrichtung, ersten Halbleiterschalter in den Hauptanschluss des Halbleiterschalters eingeprägt.

Bei einer zweiten Variante prägt die Ladeschaltung über eine Ladeleitung den Ladestrom nach dem, bezogen auf die positive Stromrichtung, zweiten Halbleiterschalter in den Hauptanschluss des Halbleiterschalters ein. Selbstverständlich können beide vorgenannten Varianten auch gleichzeitig realisiert sein.

Geschickterweise ist die Ladeschaltung und/oder die Ansteuerungseinheit durch eine Rückleitung mit den zwischen den beiden Halbleiterschaltern vorgesehenen Verbindungen verbunden. Die Ansteuerungseinheit ist in einer bevorzugten Ausgestaltung mit der Ladeschaltung zusammen realisiert, wodurch sich der schaltungstechnische Aufwand entsprechend reduziert. Die Ansteuerungseinheit wirkt über die Gate-Elektroden auf die beiden hintereinander angeordneten Halbleiterschalter und verwendet als Bezugspotential zwischen Gate und Source das zwischen den beiden Halbleiterschaltern bestehende Potential. Auch hier wird über die gleiche Leitung die Ladeschaltung geschlossen. Dieses Potential der Verbindung zwischen den beiden Halbleiterschaltern ist ein wichtiger Bezugspunkt für den später noch einzuführenden Gate-Treiber. Die Halbleiterschalter werden durch die Spannung zwischen Gate und Source ein- bzw. ausgeschaltet. Durch das gleiche Bezugspotential können somit in gleicher Weise beide Halbleiterschalter durch eine Ansteuerungseinheit gesteuert werden.

Geschickerweise ist vorgesehen, dass parallel zu den hintereinander angeordneten Halbleiterschaltern eine Diode vorgesehen ist und die wirksame Kapazität über die Diode geladen wird. Die Diode ist dabei vorzugsweise als Recoverydiode oder als Freilaufdiode ausgebildet.

Bevorzugterweise ist der bzw. die Halbleiterschalter als unipolare Halbleiterschalter ausgebildet, was einen Stromfluss in beide Richtung erlaubt. Hierzu kommen z.B. Feldeffekttransistoren, MOSFET oder JFET in Betracht. Zum Beispiel weisen JFET Transistoren aus Siliciumcarbit ebenfalls eine störende Source-Kapazität auf. Dieses Verhalten kann ebenfalls optimiert werden. Grundsätzlich eignen sich alle Feldeffekttransistorentypen mit störenden, insbesondere nicht linearen, Source-Drain Kapazitäten zur Verwendung in der erfindungsgemäßen Schaltungsanordnung.

Bei positiver Stromrichtung des durch die Halbleiterschalter fließenden Laststromes ist die Diode entsprechend gegensinnig angeordnet. In diesem normalen Steuerungszustand wird der Laststrom über die ggf. auch parallel angeordneten Reihe von Halbleiterschaltern geschickt, wo entsprechend geringere Verluste entstehen. Der Einsatz der Diode erfolgt insbesondere bei der Rückkommutierung bei umgekehrtem Stromfluss bzw. für die Aufladung der störenden wirksamen Kapazität am ersten Halbleiterschalter, bei welchem der Ladestrom über die Diode gelenkt wird.

Insbesondere ist die, bezogen auf die positive Stromrichtung an dem ersten Halbleiterschalter, wirksame Kapazität beim Kommutieren mit erheblichen Verlusten behaftet, weswegen diese bevorzugt von der Ladestromschaltung bzw. dem Ladestrom vorgeladen wird. Hierzu gibt es mehrere Strategien, z.B. einen direkten Anschluss des Ladestrompfades vor den in die positive Stromrichtung ersten Halbleiterschalter oder aber die Einbeziehung der parallel geschalteten (Freilauf-)Diode in den Ladestrompfad.

In einer bevorzugten Ausgestaltung des Vorschlages ist eine Ansteuerungseinheit für die Ansteuerung der Halbleiterschalter vorgesehen, welche insbesondere auch über den Ladestrompfad den Ladestrom gesteuert zur Verfügung stellt. In dem Ausführungsbeispiel kommutiert die Ansteuerungseinheit auch gleichzeitig die Ladestromschaltung.

Des Weiteren ist in einer erfindungsgemäßen Variante vorgesehen, dass die Schaltungsanordnung zwei gleichartige Halbleiterschalter umfasst, die gegensinnig (man könnte auch antiseriell sagen) hintereinander angeordnet sind, derart, dass die Halbleiterschalter zwischen ihren gleichartigen Anschlüssen, insbesondere an ihren Source-Anschlüssen, verbunden sind.

In dem sperrenden Zustand der Halbleiterschalter sind die jeweils zwischen Source und Drain bestehenden Bodydioden der Halbleiterschalter gegensinnig sperrend, wobei die Bodydiode an dem ersten Halbleiterschalter (bei positiver Stromrichtung) in Sperrrichtung geschaltet ist.

Für die Auslegung der in der Schaltungsanordnung vorgesehenen Halbleiterschalter ist es ausreichend, dass nur ein Halbleiterschalter eine hohe Spannungsfestigkeit aufweist. Der andere Halbleiterschalter kann dagegen eine niedrigere Spannungsfestigkeit aufweisen. Dabei ist es günstig, dass der bei positiver Stromrichtung erste Halbleiterschalter eine hohe Spannungsfestigkeit z.B. größer 300V, insbesondere größer 500V bzw. mit bis zu 600V beziehungsweise 650V bis 1200V aufweist. Dies ist insbesondere in dem geplanten Anwendungsbereich in Umrichtern von Vorteil. Bei positiver Stromrichtung fällt eine entsprechende Spannung über dem ersten Halbleiterschalter ab, der daher eine entsprechende Spannungsfestigkeit besitzen muss, die bei dem bei positiver Stromrichtung zweiten Halbleiterschalter nicht in diesem Maße gefordert ist. Hier reichen geringere Spannungsfestigkeiten, z.B. mit bis zu 30V, 50V oder 100V aus.

Geschickterweise ist ein Taktsignalgeber vorgesehen, der auf die Ansteuerungseinheit wirkt, dies ergibt die Kommutierungsfrequenz vor bzw. ist in geeigneterweise mit der Kommutierungsfrequenz synchronisiert.

In einer weiteren bevorzugten Ausgestaltung der Erfindung ist im Ladestrompfad eine Induktivität vorgesehen, die mit der wirksamen Kapazität einen Schwingkreis bildet. Dadurch ist es möglich, die wirksamen Kapazitäten an den beiden (zumindest einem) Halbleiterschalter über die Versorgungsspannung der Treiberschaltung bzw. des Gate-Treibers vorzuladen.

Alternativ zu dem Einsatz einer Induktivität ist auch ein separater Transformator im Ladestrompfad als Stromquelle für die Vorladung der wirksamen Kapazität vorgesehen. Dies hat den Vorteil, dass mit der Wahl des Übersetzungsverhältnisses des Transformators die Ladespannung beliebig einstellbar ist. Durch die Entkopplung von der Treiberspannungsversorgung kann mit hohen Ladeleistungen gearbeitet werden, ohne dass es unerwünschte Rückwirkungen auf die Treiberspannungsversorgung gibt und die galvanische Trennung verhindert ein Einkoppeln von Störungen auf die Ansteuerungsleitungen der beiden Halbleiterschalter.

Geschickterweise ist im Ladestrompfad der Induktivität bzw. dem Trafo eine Diode in Reihe geschaltet, insbesondere nachgeschaltet. Dadurch wird erreicht, dass der Schwingkreis nicht zurückschwingen kann und man erhält in Verbindung mit einer Nichtlinearität der wirksamen Ausgangskapazitäten mehr als die Verdopplungen der Treiberspannung. Dies ist insbesondere bei der Variante, bei welcher kein Transformator eingesetzt wird, eine einfache Variante, um verhältnismäßig höhere Vorladespannungen für die wirksamen Kapazitäten zu erzeugen. Insgesamt reicht hier ein Spannungspotential von ca. 20V bis 100V aus.

In diesem Zusammenhang wird insbesondere darauf hingewiesen, dass alle im Bezug auf die Vorrichtung beschriebenen Merkmale und Eigenschaften aber auch Verfahrensweisen sinngemäß auch bezüglich der Formulierung des erfindungsgemäßen Verfahrens übertragbar und im Sinne der Erfindung einsetzbar und als mitoffenbart gelten. Gleiches gilt auch in umgekehrter Richtung, das bedeutet, nur im Bezug auf das Verfahren genannte, bauliche also vorrichtungsgemäße Merkmale können auch im Rahmen der Vorrichtungsansprüche berücksichtigt und beansprucht werden und zählen ebenfalls zur Erfindung und zur Offenbarung.

In der Zeichnung ist die Erfindung schematisch dargestellt. Es zeigen:
- Fig. 1: das Schaltbild einer Halbbrückenschaltung, wie sie z.B. in Kommutierungszellen von Gleichstromstellern oder Wechselrichtern im Stand der Technik verwendet wird,
- Fig. 2a, 2b: je eine Variante der erfindungsgemäßen Schaltungsanordnung,
- Fig. 3a, 3b: zwei Ausführungsbeispiele der erfindungsgemäßen Schaltungsanordnung,
- Fig. 4: das Schaltbild einer Kommutierungszelle, vergleichbar nach Fig. 1 unter Verwendung der erfindungsgemäßen Schaltungsanordnung.

In den Figuren sind gleiche oder einander entsprechende Elemente jeweils mit den gleichen Bezugszeichen bezeichnet und werden daher, sofern nicht zweckmäßig, nicht erneut beschrieben.

Fig. 1 zeigt die Halbbrückenschaltung mit einer Kommutierungszelle nach dem Stand der Technik. Hierzu wurde bereits einleitend Stellung genommen.

Fig. 2a zeigt eine erfindungsgemäße Schaltungsanordnung, die z.B. als Schaltereinheit SE in einer Brückenschaltung gemäß Fig. 1 Verwendung finden kann. Eine Verwendung entsprechend des Anwendungsbeispiels ist in Fig. 4 gezeigt.

Die in Fig. 2a gezeigte Schaltungsanordnung besteht im Wesentlichen aus zwei an den Hauptanschlüssen in einer Reihe verbundenen Halbleiterschaltern S_{H} und S_{L}. Die positive Stromrichtung des Laststromes Iₛ ist mit einem Pfeil gekennzeichnet.

Die in diesem Ausführungsbeispiel verwendeten Halbleiterschalter S_{H} und S_{L} sind z.B. (gleichartige) normalsperrende n-Kanal-MOSFETs, wobei der Halbleiterschalter S_{H} eine hohe Spannungsfestigkeit z.B. von ca. 600V und der Halbleiterschalter S_{L} (in positiver Stromrichtung der zweite Halbleiterschalter) eine niedrige Spannungsfestigkeit, z.B. ca. 30V aufweist.

Charakteristisch bei dieser erfindungsgemäßen Schaltungsanordnung ist, dass die beiden Halbleiterschalter S_{H} und S_{L} an ihren Source-Anschlüssen S durch die Verbindung VB miteinander verbunden sind.

In positiver Stromrichtung gesehen sperrt daher die zwischen Drain D und Source S des Halbleiterschlaters S_{H} angeordnete Bodydiode D_{bH}.

Geschaltet wird der Halbleiterschalter S_{H} über eine Ansteuerungs- und Ladeschaltung 1, die auf das Gate G des Halbleiterschalters S_{H} wirkt.

Die Ansteuerungs- und Ladeschaltung 1 ist Teil der Ansteuereinheit AE. Die Ansteuereinheit AE umfasst dabei neben der Ansteuerungs- und Ladeschaltung 1 für den Halbleiterschalter S_{H} auch eine Ansteuerungs- und Ladeschaltung 2 für den zweiten Halbleiterschalter S_{L}, sowie auch eine Ansteuerungs- und Ladeschaltung 3, die der Vorladung bzw. Aufladung der an den Halbleiterschaltern wirksamen Kapazitäten C_{bH} dient.

In der Ansteuerungseinheit ist den einzelnen Ansteuerungs- und Ladeschaltungen 1, 2, 3 eine Signalgenerierung 4 vorgeschaltet. Auf die Ansteuerungseinheit AE und somit auch auf die Signalgenerierung 4 wirkt das Taktsignal TS zur Betätigung der gesamten Schaltereinheit bzw. Schaltungsanordnung SE.

Wie bereits erwähnt, sind die beiden hintereinander angeordneten Halbleiterschalter S_{H} und S_{L} über die Verbindung VB an ihren Source-Anschlüssen miteinander verbunden.

In analoger Weise wirkt auf den Gate des Halbleiterschalters S_{L} die Ansteuerungs- und Ladeschaltung 2. Bezogen auf die positive Stromrichtung ist die Bodydiode D_{bL} des zweiten Halbleiterschalters S_{L} in leitender Richtung geschaltet. Es ist klar, dass sich auch an dem zweiten Halbleiterschalter S_{L} eine parasitäre, wirksame Kapazität besteht, die aber aus Praktikabilitätsgründen nicht eingezeichnet wurde.

Der gemeinsame Verbindung VB der Source-Anschlüsse der beiden Halbleiterschalter S_{H} und S_{L} ist auch ein wichtiger Bezugspunkt für den durch die Ansteuerungseinheit gebildeten Treiber. Daher ist die Verbindung VB über die Rückleitung RL mit der Ansteuerungseinheit AE verbunden. Dadurch ist es möglich, die als MOSFET ausgebildeten Halbleiterschalter S_{H} und S_{L} über eine Spannung zwischen dem Gate und Source ein- bzw. auszuschalten.

Parallel zu den beiden hintereinander angeordneten Halbleiterschaltern S_{H} und S_{L} ist eine (Freilauf-)Diode D_{F} angeordnet, die bei positiver Stromrichtung (des Laststromes I_{S}) in Sperrrichtung geschaltet ist.

Mit dem Pfeil U_{S} ist der Spannungsabfall über den Leistungspfad der Schaltereinheit bzw. vor und nach dem hintereinander angeordneten Halbleiterschaltern S_{H} und S_{L} gekennzeichnet.

Die beiden Halbleiterschalter S_{H} und S_{L} werden bevorzugt synchron bzw. gleichartig geschaltet. Unter Umständen sind die Schaltpunkte, dort wo diese Halbleiterschalter leitend werden, aufgrund individueller Abstimmung etwas versetzt zueinander, was aber den grundsätzlichen synchronen Schaltprozess nicht beeinträchtigt. Während des Vorwärtsbetriebes ist der Strom I_{SS} durch die Schaltereinheit positiv. Während des synchronfreien Laufes ist der Strom I_{SS} durch die Schaltereinheit negativ und übernimmt den Laststrom I_{S} teilweise oder vollständig. In letzterem Fall ist der Strom I_{DF} durch die Freilaufdiode D_{F} gleich Null. Die Diode D_{F} ist z.B. als hochwertige Recoverydiode ausgebildet, die bei genügend kleinen Spannungsabfällen über die beiden Halbleiterschalter S_{H} und S_{L} während des synchronfreien Laufes nur der Kommutierung dient und eine sehr geringe Stromflussdauer aufweist. Daher ist diese Diode D_{F} relativ klein auslegbar.

Die Ansteuerungseinheit AE stellt über die Ladeschaltung 3 auch den für die Vor- bzw. Aufladung der (parasitären), an den Halbleiterschaltern S_{H} und S_{L} wirksamen Kapazitäten C_{bH} notwendige Ladung zur Verfügung. Dieser Strom wird über einen Ladestrompfad von der Ladeschaltung 3 zu den jeweiligen wirksamen Kapazitäten C_{bH} geleitet.

Dieser Ladestrompfad LSP kann erfindungsgemäß verschieden ausgebildet sein. Es wird geschickterweise zumindest teilweise das Netzwerk der Schaltungsanordnung hierfür verwendet, wozu die Hauptstromleitung HSL mit der Ladeleitung LL mit der Ladeschaltung 3 verbunden ist.

Die Hauptstromleitung HSL umfasst dabei die Drain-Source-Strecken der beiden Halbleiterschalter S_{H} und S_{L} sowie die zwischen den Source-Anschlüssen bestehende Verbindung VB.

Die Ladeschaltung 3 für die Vorladung der Kapazitäten C_{bH} ist in dem in Fig. 2a gezeigten Ausführungsbeispiel zunächst über die Ladeleitung LL mit der Hauptstromleitung HSL nach dem in positiver Stromrichtung zweiten Halbleiterschalter S_{L} verbunden. Dort fließt dann der Ladestrom I_{L}, über den in dieser Stromrichtung nicht sperrenden (Freilauf-)Diode D_{F} parallel zu dem Drain-Anschluss des bei positiver Stromrichtung ersten Halbleiterschalters S_{H}. Über den so definierten Pfad der Ladeleitung - Ladeleitung LL bis zur Hauptstromleitung -parallel geschaltete Freilaufdiode - wird die an dem Halbleiterschalter S_{H} wirksame (Ausgangs-)Kapazität C_{bH} bei gesperrten Halbleiterschaltern S_{H} und S_{L} vor- oder aufgeladen.

Geschickterweise wird daher der Ladestrom von der (gemeinsamen) Ansteuereinheit AE zur Verfügung gestellt, wodurch in einfacher Weise zwangsweise der Ladestrom I_{L} dann fließt (also der zugehörige Schalter geschlossen ist), wenn kein Strom durch die Halbleiterschalter S_{H} und S_{L} fließt, diese also abgeschaltet sind. Die Rückleitung RL unterstützt natürlich den Aufladeprozess an den wirksamen Kapazitäten C_{bH}.

Es ist klar, dass die in Fig. 2a gezeigte beispielhafte Ausgestaltung der erfindungsgemäßen Schaltungsanordnung einen modularen Aufbau einerseits, aber auch problemlos skalierbar auf der anderen Seite ist.

Fig. 2b ist mit dem Vorschlag von Fig. 2a im Wesentlichen identisch. Daher wird insofern auf die Ausführungen zu Fig. 2a verwiesen.

Geändert ist hier der Verlauf des Ladestrompfades, der für das Aufladen der wirksamen Kapazität C_{bH} hier nicht den Weg über die Diode D_{F} gewählt wird, sondern die Ladeschaltung 3 über die Ladeleitung LL in die Hauptstromleitung HSL vor dem ersten (bezogen auf die positive Stromrichtung) Halbleiterschalter S_{H} verbunden ist.

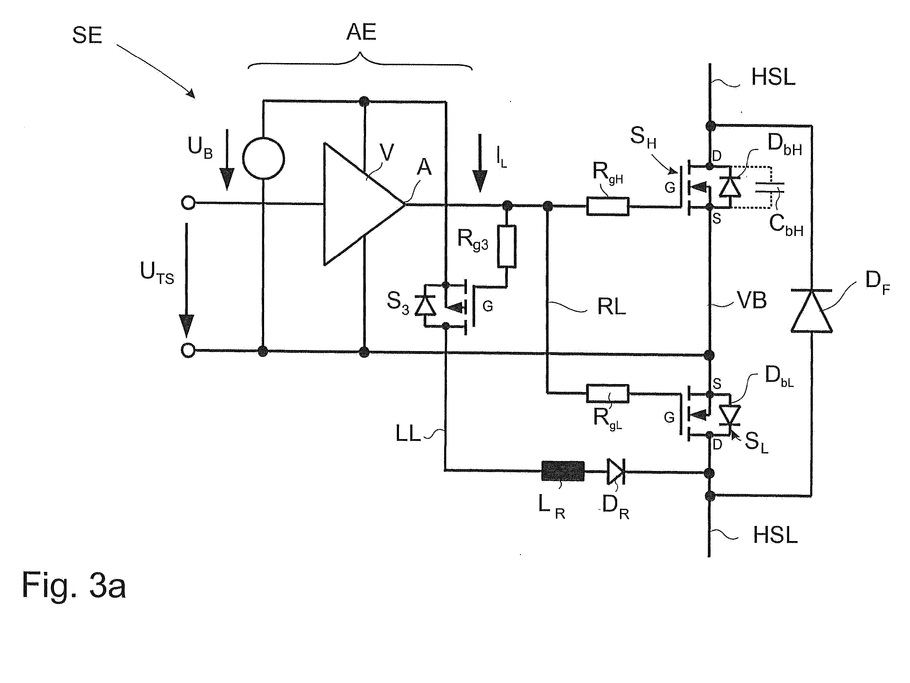

In Fig. 3a ist die erfindungsgemäße Schaltungsanordnung in einer beispielhaften Variante für die Realisierung und Ausführung der Ansteuereinheit AE gezeigt. Im Wesentlichen wird die Ansteuerungseinheit AE hier gebildet von einem Verstärker V, z.B. einem Gate-Treiber, der eingangsseitig durch die Versorgungsspannung U_{B} versorgt wird.

Über das Spannungssignal U_{TS} wird das Steuerungssignal des Taktsignales in den Verstärker V eingeprägt.

Sowohl die Versorgungsspannung U_{B} wie auch das Spannungssignal U_{TS} beziehen sich auf das Potential der zwischen den Source-Anschlüssen der Halbleiterschalter S_{H} und S_{L} an der Verbindung VB liegenden Potentials.

An dem Ausgang A des einzigen Verstärkers V werden in geschickter Weise drei unterschiedliche Halbleiterschalter S_{H} und S_{L} und S₃ geschaltet. Dabei sind die Gates der als MOSFET ausgebildeten Halbleiterschalter S_{H} und S_{L} über Gate-Widerstände R_{gH} bzw. R_{gL} parallel an den Ausgang A des Verstärkers V angeschlossen. Dadurch können durch ein Spannungssignal am Ausgang A beide Gates der beiden Halbleiterschalter S_{H} und S_{L} gesteuert werden. Eine individuelle Anpassung erfolgt durch die Gate-Widerstände R_{gH} bzw. R_{gL}, wodurch sich ggf. unterschiedliche Schalt- bzw. Öffnungscharakteristika der einzelnen Halbleiterschalter S_{H} und S_{L} einstellen lassen. Umgekehrt können durch die Gate-Widerstände R_{gH} bzw. R_{gL} (dies können nicht nur einfache ohmsche Widerstände, sondern auch komplexere RL-Netzwerke, gegebenenfalls auch mit Diode sein) auch Bauteilunterschiede kompensiert werden.

Die Versorgungsspannung U_{B} versorgt nicht nur den Verstärker V, sondern stellt auch den Ladestrom I_{L} zur Verfügung, der über den Schalter S₃, und die in Reihe geschalteten Induktivität L_{R} und die Diode D_{R} auf die Hauptstromleitung HSL, in positiver Stromrichtung nach dem zweiten Halbleiterschalter S_{L} eingespeist wird.

Der Halbleiterschalter S₃ ist wiederum als MOSFET, in diesem Fall aber als Typ p-MOSFET und insofern invertiert zu der Art des Halbleiterschalters S_{H} und S_{L} ausgeführt. Das Gate G dieses Halbleiterschalters S₃ wird ebenfalls über den Ausgang A des Verstärkers V gesteuert, hierzu ist ein separater Gate-Widerstand R_{g3} vorgesehen.

Das Schaltverhalten ist nun so, dass bei abgeschalteten Schalteinheiten, d.h. bei geöffneten Halbleiterschaltern S_{H} und S_{L}; (es fließt kein Strom durch die Schalteinheit über die Hauptstromleitung) der Halbleiterschalter S₃ geschlossen ist und so der Ladestrom I_{L} in die Schaltungsanordnung zwangsweise fließt.

Durch die geschickte Anordnung des Halbleiterschalters S₃, im Ladestrompfad, der für die Vorladung der wirksamen Kapazität C_{bH} dient und invers zu den beiden in Reihe geschalteten Halbleiterschaltern S_{H} und S_{L} ausgebildet ist im Ladestrompfad, wird der Ansteuerungsaufwand erheblich verringert, da alle Gate-Anschlüsse der als MOSFETs ausgebildeten Halbleiterschaltern S₃, S_{H} und S_{L} je durch eigenständige Gate-Widerstände R_{g3}, R_{gH} und R_{gL} an dem Ausgang A des Verstärkers V angeschlossen sind.

Geschickterweise ist die Dimensionierung der Gate-Widerstände R_{g3}, R_{gH} und R_{gL} eine zeitliche Abstimmung der Schaltvorgänge der Halbleiterschalter S₃, S_{H} und S_{L} möglich, ohne dabei das grundsätzlich gleichartige Verhalten der Schaltungsanordnung bzw. ihre Synchronität zu beeinträchtigen. Die Anpassung der Gate-Widerstände R_{g3}, R_{gH} und R_{gL} ergibt sich auch dem Typ des eingesetzten Halbleiterschalters und dem von der Schaltereinheit SE und dem Taktsignal TS vorgegebenen Verlauf.

Wie bereits ausgeführt, ist in der Ladeleitung LL eine Induktivität L_{R} und in Reihe geschaltet, in Stromrichtung danach eine Diode D_{R} vorgesehen.

Zusammen mit der wirksamen Kapazität C_{bH} bildet sich somit ein Schwingkreis aus, der aufgrund der Diode D_{R} nicht zurückschwingen kann, und man erreicht hiermit insbesondere in Verbindung mit der Nichtlinearität der wirksamen Ausgangskapazität C_{bH} hieraus eine Vervielfachung, insbesondere Verdopplung der die drei Gate-Treiber versorgenden Versorgungsspannung U_{B}. Somit kann durch einfache Mittel eine Ladestromschaltung realisiert werden.

Mit einer z.B. zur Verfügung stehenden Versorgungsspannung U_{B} des Gate-Treibers von z.B. 12V ist es möglich, die wirksame Ausgangskapazität C_{bH} auf die erforderlichen ca. 20V bis 100V aufzuladen. Die Spannung schwingt auf dem Kondensator C_{bH} im Idealfall auf mehr als die doppelte Quellenspannung, hier die den Gate-Treiber versogende Versorgungsspannung U_{B}. Da jetzt die Kondensatorspannung höher ist als die Quellenspannung, würde ohne die Diode D_{R} das ganze wieder zurück schwingen, bis die Spannung an dem Kondensator C_{bH} wieder Null ist. Danach beginnt der Zyklus wieder. Es ist daher günstig, hier eine Diode in Reihe zur Drossel bzw. Induktivität einzubauen, wodurch die maximale Spannung auf dem Kondensator, welche die Kapazität C_{bH} bildet, stehen bleibt, es bildet sich keine stationäre Oszillation aus.

Praktisch gibt es hierbei aber Verluste, die den Schwingungsvorgang bedämpfen, z.B. ist die Ausgangskapazität C_{bH} nichtlinear. Die Kapazität nimmt mit steigender Spannung ab, was energetisch gesehen wie ein Verstärker für die Spannung wirkt. Damit ist es gleichwohl möglich mit einer geringen Versorgungsspannung des Treibers und unvermeidbaren Diodenspannungabfälle eine genügend hohe Vorladespannung der Ausgangskapazitäten C_{bH} an dem Halbleiterschalter S_{H} bzw. S_{L} zu erzielen.

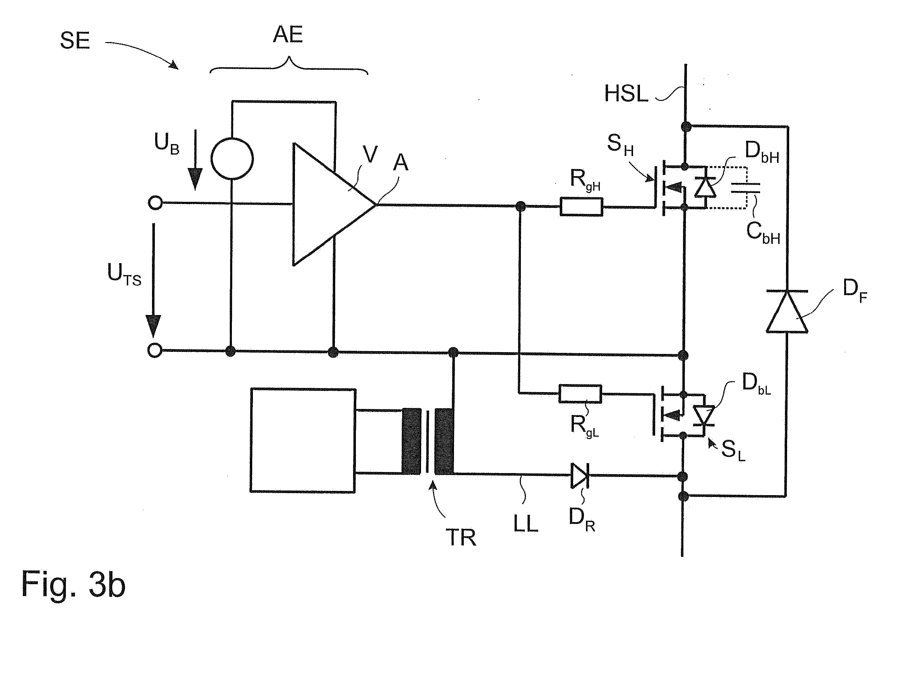

Im Gegensatz zu der Lösung nach Fig. 3a zeigt der Vorschlag von Fig. 3b anstelle der Anordnung eines Schalters S₃ den Einsatz eines separaten Transformators TR, der über die Ladeleitung LL und der Diode D_{R} an die Hauptstromleitung, in positiver Stromrichtung gesehen, nach dem zweiten Halbleiterschalter S_{L} angeschlossen ist. In Fig. 3b ist kein weiterer Schalter in der Ladungsleitung LL vorgesehen, dies ist z.B. primärseitig am Transformator realisiert oder natürlich auch in der Ladungsleitung in ähnlicher Weise wie in Fig. 3a realisierbar.

In Fig. 4 ist die erfindungsgemäße Schaltungsanordnung in einer Halbbrückenschaltung oder auch Brückenzweig, wie sie z.B. für Gleichstromsteller oder Umrichter typisch ist, in zweifacher Weise realisiert, wobei sich zwischen den beiden Schaltereinheiten SE₁ und SE₂ ein Ausgangsstrompfad ASP angeschlossen ist, über den die ausgangsseitige Spannung U₂ (diese fällt über die zweite Schaltereinheit SE₂ ab) abgreifbar ist.

Die jetzt mit der Anmeldung und später eingereichten Ansprüche sind ohne Präjudiz für die Erzielung weitergehenden Schutzes.

Sollte sich hier bei näherer Prüfung, insbesondere auch des einschlägigen Standes der Technik, ergeben, dass das eine oder andere Merkmal für das Ziel der Erfindung zwar günstig, nicht aber entscheidend wichtig ist, so wird selbstverständlich schon jetzt eine Formulierung angestrebt, die ein solches Merkmal, insbesondere im Hauptanspruch, nicht mehr aufweist. Auch eine solche Unterkombination ist von der Offenbarung dieser Anmeldung abgedeckt.

Es ist weiter zu beachten, dass die in den verschiedenen Ausführungsformen beschriebenen und in den Figuren gezeigten Ausgestaltungen und Varianten der Erfindung beliebig untereinander kombinierbar sind. Dabei sind einzelne oder mehrere Merkmale beliebig gegeneinander austauschbar. Diese Merkmalskombinationen sind ebenso mit offenbart.

Die in den abhängigen Ansprüchen angeführten Rückbeziehungen weisen auf die weitere Ausbildung des Gegenstandes des Hauptanspruches durch die Merkmale des jeweiligen Unteranspruches hin. Jedoch sind diese nicht als ein Verzicht auf die Erzielung eines selbständigen, gegenständlichen Schutzes für die Merkmale der rückbezogenen Unteransprüche zu verstehen.

Merkmale, die nur in der Beschreibung offenbart wurden oder auch Einzelmerkmale aus Ansprüchen, die eine Mehrzahl von Merkmalen umfassen, können jederzeit als von erfindungswesentlicher Bedeutung zur Abgrenzung vom Stande der Technik in den oder die unabhängigen Anspruch/Ansprüche übernommen werden, und zwar auch dann, wenn solche Merkmale im Zusammenhang mit anderen Merkmalen erwähnt wurden beziehungsweise im Zusammenhang mit anderen Merkmalen besonders günstige Ergebnisse erreichen.

## Patentansprüche

1. Verfahren zum Aufladen einer an den Hauptanschlüssen eines Halbleiterschalters (S_{H}) wirksamen Kapazität (C_{bH}), wobei eine Vorladung der wirksamen Kapazität (C_{bH}) über einen Ladestrompfad (LSP) gesteuert wird und in Reihe zu dem Halbleiterschalter (S_{H}) mindestens ein weiterer Halbleiterschalter (S_{L}) vorgesehen ist.

2. Verfahren nach Anspruch 1, **dadurch gekennzeichnet, dass** parallel zu den mindestens zwei in Reihe angeordneten Halbleiterschaltern (S_{H}, S_{L}) eine Diode (D_{F}) angeordnet ist und der für das Vor- bzw. Aufladen der Kapazität (C_{bH}) vorgesehene Ladestrom (I_{L}) über die Diode (D_{F}) geleitet wird und/oder die Vor- oder Aufladung der Kapazität (C_{bH}) dann erfolgt, wenn kein Laststrom (I_{S}) durch die hintereinander angeordneten Halbleiterschalter (S_{H}, S_{L}) fließt.

3. Verfahren nach Anspruch 1 oder 2, **dadurch gekennzeichnet, dass** die beiden, bevorzugt gleichartigen, hintereinander angeordneten Halbleiterschalter (S_{H}, S_{L}) von einer Ansteuerungseinheit (AE) synchron bzw. gleichartig angesteuert werden und/oder eine zwangsweise Vor- bzw. Aufladung vorgesehen ist und/oder eine Vor- bzw. Aufladung beider bzw. aller an den Halbleiterschaltern (S_{H,} S_{L}) wirksamen Kapazitäten erfolgt.

4. Schaltungsanordnung, umfassend mindestens zwei an ihren Hauptanschlüssen (S, D) in Stromleitungsrichtung hintereinander angeordnete Halbleiterschalter (S_{H}, S_{L}), wobei mindestens einem Halbleiterschalter (S_{H}) eine wirksame Kapazität (C_{bH}) zugeordnet ist und zur zwangsweisen Steuerung einer Vorladung der wirksamen Kapazität (C_{bH}) ein Ladestrompfad (LSP) vorgesehen ist.

5. Schaltungsanordnung nach Anspruch 4, **dadurch gekennzeichnet, dass** eine Ladeschaltung (3) vorgesehen ist, die über den Ladestrompfad (LSP) die Kapazität (C_{bH}) auf- bzw. vorlädt und/oder eine Ansteuerungseinheit (AE) für die Ansteuerung der Halbleiterschalter vorgesehen ist und insbesondere über den Ladestrompfad (LSP) den Ladestrom (I_{L}) gesteuert zur Verfügung stellt.

6. Schaltungsanordnung nach Anspruch 4 oder 5, **dadurch gekennzeichnet, dass** die Ladeschaltung (3) über eine Ladeleitung (LL) den Ladestrom (I_{L}) vor dem, bezogen auf die positive Stromrichtung, ersten Halbleiterschalter (S_{H}) in den Hauptanschluss des Halbleiterschalters (S_{H}) einprägt und/oder die Ladeschaltung (3) über eine Ladeleitung (LL) den Ladestrom (I_{L}) nach dem, bezogen auf die positive Stromrichtung, zweiten Halbleiterschalter (S_{L}) in den Hauptanschluss des Halbleiterschalters (S_{L}) einprägt.

7. Schaltungsanordnung nach einem der Ansprüche 4 bis 6, **dadurch gekennzeichnet, dass** die Ladeschaltung (3) und/oder die Ansteuerungseinheit (AE) durch eine Rückleitung (RL) mit der zwischen den beiden Halbleiterschaltern (S_{H}, S_{L}) vorgesehenen Verbindung (VB) verbunden ist.

8. Schaltungsanordnung nach einem der Ansprüche 4 bis 7, **dadurch gekennzeichnet, dass** parallel zu den hintereinander angeordneten Halbleiterschaltern (S_{H}, S_{L}) eine Diode (D_{F}) angeordnet ist und
die wirksame Kapazität (C_{bH}) über die Diode (D_{F}) geladen wird und insbesondere die Diode (D_{F}) als Freilaufdiode ausgebildet ist
und/oder
bei positiver Stromrichtung des durch die Halbleiterschalter (S_{H}, S_{L}) fließenden Laststromes (I_{S}) die Diode (D_{F}) in Sperrrichtung angeordnet ist.

9. Schaltungsanordnung nach einem der Ansprüche 4 bis 8, **dadurch gekennzeichnet, dass** der Halbleiterschalter (S_{H}, S_{L}) als unipolarer Halbleiterschalter ausgebildet ist und/oder der Halbleiterschalter (S_{H}, S_{L}) als Feldeffekttransistor, MOSFET, oder JFET ausgebildet ist.

10. Schaltungsanordnung nach einem der Ansprüche 4 bis 9, **dadurch gekennzeichnet, dass** der bei positiver Stromrichtung erste Halbleiterschalter (S_{H}) mit hoher Spannungsfestigkeit zum Beispiel größer 300V, insbesondere größer 500V bzw. mit bis zu 650V oder 1200V ist und/oder der bei positiver Stromrichtung zweite Halbleiterschalter (S_{L}) mit geringer Spannungsfestigkeit zum Beispiel mit bis zu 30, 50 oder 100V ist.

11. Schaltungsanordnung nach einem der Ansprüche 4 bis 10, **dadurch gekennzeichnet, dass** die an dem, bezogen auf die positive Stromrichtung, ersten Halbleiterschalter (S_{H}) wirksame Kapazität (C_{bH}) von dem Ladestrom (I_{L}) vorgeladen wird und/oder die Schaltungsanordnung (S_{E}) zwei gleichartige Halbleiterschalter (S_{H}, S_{L}) umfasst, die gegensinnig hintereinander angeordnet sind, derart, dass die Halbleiterschalter (S_{H}, S_{L}) zwischen ihren gleichartigen Anschlüssen, insbesondere an ihren Source-Anschlüssen verbunden (VB) sind.

12. Schaltungsanordnung nach einem der Ansprüche 4 bis 11, **dadurch gekennzeichnet, dass** ein Taktsignalgeber (TS) vorgesehen ist, der auf die Ansteuerungseinheit (AE) wirkt und/oder die Ansteuerungseinheit (AE) nur einen Verstärker (V), zum Beispiel einen Gate-Treiber aufweist.

13. Schaltungsanordnung nach einem der Ansprüche 4 bis 12, **dadurch gekennzeichnet, dass** der Ausgang (A) des Verstärkers (V) insbesondere über Gate-Widerstände (R_{gH}, R_{gL}) auf die Gate-Anschlüsse (G) der als MOSFETs ausgebildeten Halbleiterschalter (S_{H}, S_{L}) wirkt und/oder im Ladestrompfad (LSP) für die Vorladung der wirksamen Kapazität (C_{bH}) ein Halbleiterschalter (S₃) vorgesehen ist, der invers zu den beiden in Reihe geschalteten Halbleiterschaltern (S_{H}, S_{L}) ausgebildet ist, und dessen Gate-Anschluss (G) über einen weiteren Gate-Widerstand (R_{g3}) an dem Ausgang (A) des Verstärkers (V) angeschlossen ist, wobei insbesondere durch die Dimensionierung der Gate-Widerstände (R_{gH}, R_{gL}, R_{g3}) eine zeitliche Abstimmung der Schaltvorgänge der Halbleiterschalter erfolgt.

14. Schaltungsanordnung nach einem der Ansprüche 4 bis 13, **dadurch gekennzeichnet, dass** eine Induktivität (L_{R}) im Ladestrompfad (LSP) mit der wirksamen Kapazität (C_{bH}) einen Schwingkreis bildet und/oder im Ladestrompfad (LSP) ein Transformator (TR) als Stromquelle für die Vorladung der wirksamen Kapazität (C_{bH}) vorgesehen ist, wobei insbesondere der Induktivität (L_{R}) bzw. dem Transformator (TR) im Ladestrompfad (LSP) eine Diode (D_{R}) in Reihe geschaltet, insbesondere nachgeschaltet ist.

15. Gleichstromsteller oder Umrichter mit einer Schaltungsanordnung nach einem der Ansprüche 4 bis 14.
